# EUROPEAN PATENT APPLICATION

(11) **EP 4 664 512 A1**
(43) Date of publication of application: **17.12.2025**
(21) Application number: 24181546.3
(22) Date of filing: 11.06.2024
(51) Int. Cl.: H01L 21/8234, H01L 29/06, H01L 29/423, H01L 29/775

(54) **A METHOD FOR FORMING A SEMICONDUCTOR STRUCTURE, AND A SEMICONDUCTOR STRUCTURE**

(71) Applicant: Imec VZW, 3001 Leuven (BE)
(72) Inventor: HIBLOT, Gaspard, deceased (BE); CHEN, Rongmei, 3001 Heverlee (BE); MIRABELLI, Gioele, 3000 Leuven (BE)
(74) Representative: AWA Sweden AB

(57) **Abstract**

A method for forming a semiconductor structure (1), the method comprising:
forming a fin (20) on top of a substrate (10);
forming a sacrificial gate (30) straddling the fin (20);
forming first (40) and second (50) gate spacers on opposite sides of the sacrificial gate (30);
forming a first trench (60) between the first (40) and second (50) gate spacer, by etching the sacrificial gate (30);
forming a hole (80) by etching from the frontside (11) of the substrate (10), the hole (80) extending from a bottom (61) of the first trench (60) towards a backside (12) of the substrate (10), said act of forming the hole (80) being subsequent to said act of etching the sacrificial gate (30);
depositing metal in the first trench (60) and in the hole (80);
etching the substrate (10), to expose the metal in the hole (80);
forming a backside metal track (101) on the exposed metal.

## Description

### TECHNICAL FIELD

The present inventive concept relates, in general, to a semiconductor structure and a method for forming the semiconductor structure.

### BACKGROUND

Modern semiconductor integrated circuit technology includes various types of field-effect transistors (FETs). A FET generally comprises at least one channel extending horizontally between a source and a drain, the at least one channel comprising a semiconductor. Further, the FET generally comprises a gate for controlling a current through the at least one channel.

One notable example of a FET is the nanosheet FET (NSFET). The NSFET comprises at least one channel, in the form of a nanosheet, extending horizontally between a source and a drain. The gate of the NSFET may extend around each channel to form a gate-all-around (GAA).

Another notable example of a FET is a stack of NSFETs comprising at least a first and a second NSFET, the second NSFET being stacked on top of the first NSFET. An example is the so-called complementary FET (CFET), wherein one NSFET of the stack of NSFETs is p-type and the other is n-type.

Another notable example of a FET is the forksheet FET. The forksheet FET comprises a pair of transistors being arranged side by side, in relatively close proximity, and separated by an insulating wall. Each of the pair of transistors comprises at least one channel, in the form of a nanosheet, extending horizontally between a source and a drain. Each transistor of the pair of transistors is controlled by a fork-shaped gate arranged at three sides of the channels.

### SUMMARY

It is an objective of the present inventive concept to enable a compact semiconductor structure. In particular, it is an objective to enable a compact transistor, such as a compact NSFET.

It is a further objective of the present inventive concept to enable a high-quality transistor.

It is a further objective of the present inventive concept to facilitate self-alignment between parts of the transistor. It is a further objective of the present inventive concept to facilitate easy and/or low-cost manufacturing of the transistor.

These and other objectives of the inventive concept are at least partly met by the invention as defined in the independent claims. Preferred embodiments are set out in the dependent claims.

In the following, relative spatial terms such as "top", "bottom", "lower", "vertical", "stacked on top of", are to be understood as denoting locations or directions within a frame of reference of the semiconductor structure. In particular, the terms may be understood in relation to a normal direction to a substrate on which a fin of the semiconductor structure is formed. Correspondingly, terms such as "lateral" and "horizontal" are to be understood as locations or directions parallel to the substrate.

A first direction may be understood as a direction in which the current of the finished transistor flows. A second direction may be understood as a direction transverse to the first direction. A third direction may be understood as the vertical or bottom-up direction. The first and second directions may be parallel to the substrate. The third direction may be normal to the substrate.

The term "frontside of the substrate" refers to the side of the substrate facing the top of the substrate. Similarly, the term "backside of the substrate" refers to the side of the substrate facing the bottom of the substrate.

According to a first aspect, there is provided a method for forming a semiconductor structure, the method comprising:
forming a fin comprising at least one channel, the at least one channel comprising a semiconductor, the fin being arranged on top of a substrate;
forming a sacrificial gate straddling the fin;
forming a first gate spacer and a second gate spacer, the first and the second gate spacer straddling the fin and being arranged on opposite sides of the sacrificial gate;
forming a first trench between the first and the second gate spacer, by etching, from a frontside of the substrate, the sacrificial gate;
forming a hole by etching from the frontside of the substrate, the hole extending from a bottom of the first trench towards a backside of the substrate, said act of forming the hole being subsequent to said act of etching the sacrificial gate;
depositing metal in the first trench and in the hole such that the metal deposited in the first trench forms at least part of a gate for the at least one channel of the fin;
etching the substrate from the backside of the substrate, to expose at least part of the metal in the hole;
forming a backside metal track on the exposed metal, wherein the backside metal track is in electrical connection with the gate by the metal in the hole.

The semiconductor structure formed by the method may be part of a FET. In particular, the semiconductor structure may be part of a NSFET. Alternatively, the semiconductor structure may be a semiconductor structure for manufacturing a FET, such as a NSFET. Thus, the semiconductor structure may be a semiconductor structure which, when processed further, may form a FET. In the following, the semiconductor structure will primarily be described as a semiconductor structure for manufacturing a NSFET.

According to the method, the backside metal track is in electrical connection with the gate by the metal in the hole. Thus, the metal in the hole may be referred to as a via. The backside metal track may be a signal track. Accordingly, a signal on the signal track may be applied to the gate by the via.

According to the method, the via is formed by etching the hole from the frontside of the substrate. It is a realization that etching from the frontside enables a high degree of control of the position of the hole, and thereby a high degree of control of the position of the via.

It is a further realization that forming the hole subsequent to the act of etching the sacrificial gate, enables the hole (and thereby the via) being self-aligned with a region between the first and the second gate spacer. Thereby, the high degree of control of the position of the via is further ensured. For example, the hole may be etched selectively. In other words, the hole may be formed by an etchant having a low etch rate on the material of the first and the second gate spacer. In other words, the first and the second gate spacer may act as an etch mask. Thus, the hole may be prevented from deviating, in a lateral direction, outside the boundaries set by the first and the second gate spacer. For example, a side wall of the hole may be aligned with the first or second gate spacer. In particular, a first side wall of the hole may be aligned with the first gate spacer and a second side wall of the hole may be aligned with the second gate spacer.

The high degree of control of the position of the via means that the risk of an incorrectly positioned via is small. For example, the risk of an incorrectly positioned via which creates a short circuit, e.g. a short circuit to a source/drain region, is small. Thus, a high-quality transistor, e.g. NSFET, is enabled. Further, due to the high degree of control of the position of the via, the semiconductor structure may be designed within a smaller area without risking a short circuit. Thus, a compact transistor, e.g. NSFET, is enabled. Further, easy and/or low-cost manufacturing is enabled by etching from the front and/or by the self-alignment of the via.

Further, since the hole is etched after etching the sacrificial gate the hole may also be etched after forming the first and second gate spacers. Thus, the hole may be free from gate spacer material which may clog the hole and obstruct deposition of metal in the hole.

In accordance with the above, a semiconductor structure is enabled wherein the hole is self-aligned with a region between the first and the second gate spacer.

Thus, according to a second aspect, there is provided a semiconductor structure, the semiconductor structure comprising:
a fin comprising at least one channel, the at least one channel comprising a semiconductor;
a first gate spacer and a second gate spacer, the first and the second gate spacer straddling a top side of the fin;
a gate for the at least one channel of the fin, the gate straddling the top side of the fin and being arranged between the first and the second gate spacer, the gate comprising metal filling a first trench, the first trench being arranged between the first and the second gate spacer;
a hole filled with metal, the hole extending downwards from a bottom of the first trench, the hole being self-aligned with a region between the first and the second gate spacer;
a backside metal track in electrical connection with the gate by the metal in the hole.

A semiconductor structure according to the second aspect may have the same advantages, or similar advantages, as the advantages described in conjunction with the first aspect.

The fin may be formed from a stack of layers arranged on the substrate, e.g. epitaxially grown on the substrate. The stack of layers may comprise channel layers and sacrificial layers. Each channel layer may be sandwiched between two sacrificial layers. The fin may be etched out of the stack of layers. Thus, each channel layer of the fin may form a channel in the form of a nanosheet. A fin comprising channel layers and sacrificial layers may be used to manufacture a NSFET. However, it should be understood that, as an alternative, the entire fin may be a channel, such that a FinFET may be manufactured.

Continuing on the NSFET example. Each channel layer of the stack of layers may have a thickness in a range of 3-10 nm. The fin may have a width in a range of 10-30 nm. Accordingly, each channel may have a thickness in a range of 3-10 nm and a width in a range of 10-30 nm. The above dimensions are given as examples, other thicknesses and/or widths are possible.

Channel layers and sacrificial layers may comprise Si and/or Ge. Channel layers and sacrificial layers may have different compositions. Thereby, selective etching of sacrificial layers is enabled. In particular, channel layers may comprise Si (e.g. solely Si) and sacrificial layers may comprise SiGe. The sacrificial layers may be removed at a later stage of the processing, e.g. before depositing the metal of the gate. Thus, in the finished NSFET, the gate may extend around the channels to form a gate-all-around (GAA).

The fin may extend in a first direction, the first direction may be understood as the direction in which the current of the channels flows in the finished transistor. The fin may comprise two opposing lateral side faces and a top face. A bottom face of the fin may be facing the substrate. Two opposing lateral end faces of the fin may be formed during the manufacturing of the transistor, e.g. during what is commonly called source/drain recessing. Source/drain regions may be formed on the end faces, e.g. by epitaxial growth.

The sacrificial gate is a sacrificial structure that may act as a dummy gate. As mentioned, the sacrificial gate straddles the fin. Thus, the sacrificial gate may be arranged on a respective portion of the two opposing lateral side faces and the top face. The sacrificial gate may extend in a second direction, the second direction being transverse to the fin. The sacrificial gate is intended to be at least partially etched. The sacrificial gate may comprise e.g. amorphous silicon or polycrystalline silicon.

The sacrificial gate may be formed by encasing the fin in a layer of sacrificial gate material and arranging a hardmask above, e.g. a hardmask line extending in the second direction across the fin. Unmasked portions of the sacrificial gate material may then be removed, e.g. by etching, thereby leaving the sacrificial gate straddling the fin. By straddling it is meant that the sacrificial gate at least partially covers the two lateral side faces of the fin and the top face of the fin. A similar interpretation of the term straddle is intended when used in connection to other features throughout the application.

As mentioned, the first and second gate spacers straddles the fin and are arranged on opposite sides of the sacrificial gate. The first gate spacer may be arranged on a first side surface of the sacrificial gate. Said side surface may be orthogonal to the first direction. Similarly, the second gate spacer may be arranged on a second side surface of the sacrificial gate. Said side surface may be orthogonal to the first direction. The first and second gate spacers may be conformally deposited, e.g. by atomic layer deposition (ALD), on the opposite side surfaces of the sacrificial gate. The material of the first and the second gate spacer may be a silicon nitride, e.g. Si₃N₄.

The first and second gate spacer may extend in parallel with the sacrificial gate. The first gate spacer and the second gate spacer may extend in the second direction. In other words, the first and second gate spacer may sandwich the sacrificial gate.

As mentioned, the first trench is formed between the first and the second gate spacer, by etching, from a frontside of the substrate, the sacrificial gate. Thus, the sacrificial gate may be removed, e.g. completely removed. The space created by the removal of the sacrificial gate may form the first trench. Thus, the first trench may extend in parallel with the first gate spacer and the second gate spacer. The first trench has a width and a length, wherein the width extends in the direction between the first gate spacer and the second gate, and the length extends parallel to the first and second gate space. In other words, the width of the first trench extends in the first direction, and the length of the first trench extends in the second direction.

The first trench may be formed by an etchant having a lower etch rate on the first and second gate spacer than on the sacrificial gate. The first gate spacer and the second gate spacer may comprise silicon nitride or any other suitable dielectric material. The etch rate of the etchant may thus have an etch rate for etching the material of the first and the second gate spacer (e.g. silicon nitride), that is lower than the etch rate for etching the material of the sacrificial gate (e.g. amorphous or polycrystalline silicon). The material of the first gate spacer and the second gate spacer may be chosen so that the contact/gate parasitic capacitances of the finished transistor is low.

As mentioned, the hole is formed by etching from the frontside of the substrate. The hole extends from the bottom of the first trench towards the backside of the substrate.

The hole may be etched into a shallow trench isolation. Accordingly, the hole may extend into the shallow trench isolation. The shallow trench isolation may be electrical isolation which laterally surrounds a bottom portion of the fin. The shallow trench isolation may comprise an oxide, e.g. SiO₂. The shallow trench isolation may be deposited, e.g. by chemical vapor deposition, such as plasma enhanced chemical vapor deposition, prior to forming the sacrificial gate. Further, the hole may extend vertically into the shallow trench isolation. Further, the hole may extend beyond the shallow trench isolation, e.g. into the substrate. Alternatively, if there is no shallow trench isolation, the hole may extend directly into the substrate.

The shallow trench isolation may electrically isolate transistor components from each other, e.g. electrically isolate one transistor from another. Similarly, when the hole extends into the shallow trench isolation, the via formed in the hole may be electrically isolated from other components by the shallow trench isolation.

The hole may have a width and a depth. The width of the hole may be the same as the width of the trench. Alternatively, the width of the hole may be smaller than the width of the trench. The width of the hole may be the same in the first direction and in the second direction. Alternatively, the width of the hole may be different in the first direction and in the second direction. The depth of the hole may extend through parts of the substrate. Alternatively, the depth of the hole may extend all the way through the substrate.

In the step of forming the hole by etching, an etch rate may be higher for a material at the bottom of the first trench than for a material of the first and the second gate spacer. Thus, the etchant used for forming the hole may have a low etch rate on the material of the first and second gate spacer. Thus, the material at the bottom of the first trench may be selectively etched. This facilitates accurate etching and/or easy manufacturing and/or low-cost manufacturing. The hole may be dry etched e.g. by plasma etching, or wet etched.

As previously mentioned, the material of the first and the second gate spacer may be a silicon nitride, e.g. Si₃N₄. Silicon nitride may have a low etch rate, thereby, selective etching is facilitated.

A mask layer may be used for forming the hole. Thus, the method may further comprise:
depositing, prior to forming the hole, a mask layer comprising a mask opening, the mask opening exposing a part of the first trench and a part of a top surface of at least one of the first and the second gate spacer, wherein an extent of the hole is defined by the part of the first trench exposed by the mask opening.

The etchant used for forming the hole may have a low etch rate on the material of the mask layer and a low etch rate on the material of the first and second gate spacer. Thus, the mask opening may together with the first and second gate spacer define the extent of the hole. The mask opening may be lithographically defined. A lithographic process may not necessarily be completely accurate. Therefore, even if the mask opening is intended to be arranged centrally between the first and second gate spacer, it may be shifted slightly towards one of the gate spacers.

In a situation where the mask opening is not shifted and/or does not expose a top surface of any of the gate spacers, the mask opening may expose solely part of the first trench. Thus, in this situation, the extent of the hole may be defined by the mask opening itself.

In a situation where the mask opening is shifted and/or exposes a top surface of one of the gate spacers, the mask opening may expose both the part of the first trench and the gate spacer top surface. In this situation, the extent of the hole may be defined by the part of the first trench exposed by the mask opening. The exposed gate spacer may then act as an additional mask for the hole. Thereby, a side wall of the hole may be aligned with said gate spacer.

A thickness of the first gate spacer and the second gate spacer may be at least 4 nm. This may give sufficient error margin for the lithographic process. In other words, the mask opening may be shifted from its intended position so as to expose up to 4 nm to the side of the first trench, without the hole deviating from its intended position. Further, when the thickness of the first and second gate spacers are at least 4 nm, the first and second gate spacers provide sufficient electrical isolation for the gate of the finished device. Further advantageously, a thickness of the first gate spacer and the second gate spacer may be at least 5 nm. Further, a thickness of the first gate spacer and the second gate spacer may be below 7 nm. Thereby, the semiconductor structure may be kept compact.

The first gate spacer and the second gate spacer may be separated by a separating distance, and a width of the hole in a direction of the separating distance may be smaller than or equal to the separating distance. For example, if the mask opening exposes both a top surface of the first gate spacer and a top surface of the second gate spacer, the width of the hole may be equal to the separating distance between the first and second gate spacers. If the mask opening exposes only a top surface of one of the first and second gate spacers, the width of the hole may be smaller than the separating distance between the first and second gate spacers. The separating distance between the first and second gate spacers may be at least 8 nm, such as at least 12 nm. The separating distance between the first and second gate spacers may be in the range of 12-20 nm. It may be advantageous when a width of the hole in a direction of the separating distance is equal to the separating distance. Thus, the separating distance between the gate spacers may be utilized fully. Thus, a large via may be formed. Thereby, the resistance of the via may be low. Accordingly, it may be advantageous if the mask opening exposes both a top surface of the first gate spacer and a top surface of the second gate spacer.

As mentioned, metal is deposited in the first trench and in the hole. Metal deposited in the first trench forms at least part of a gate for the at least one channel of the fin. Metal deposited in the hole may, as mentioned, be referred to as a via. Metal may be deposited in the hole and in the first trench simultaneously, or separately. The metal may be deposited by physical vapor deposition and/or conformal deposition. The metal deposited in the hole may fill the hole with metal. The metal that is deposited within the hole may be in electrical contact with the metal deposited in the first trench.

If the fin comprises a channel sandwiched between sacrificial layers, said channel may be released before said act of depositing metal in the first trench, e.g. by etching the sacrificial layers. Thus, the gate may extend around said channel.

Further, a gate dielectric may be deposited on the at least one channel of the fin before said act of depositing metal in the first trench. The gate dielectric may extend around the at least one channel. The gate dielectric may be arranged between each channel and the metal of the gate. The gate dielectric may be a conventional a high-k dielectric e.g. HfO₂, HfSiO, LaO, AlO or ZrO. The gate dielectric may be conformally deposited, e.g. by ALD. The gate dielectric may be deposited also in the hole. Thus, the gate dielectric may contribute to electrically isolating the via. The gate dielectric and the metal may be the only materials deposited in the hole. It is a realization that if the semiconductor structure is not produced according to the present method, wherein the hole is formed subsequent to the etching the sacrificial gate, other materials may additionally be deposited in the hole. For example, in such an alternative method it is conceivable that gate spacers are formed after forming the hole. This may result in gate spacer material being deposited in the hole which may clog the hole. For example, the gate dielectric may be thinner than the gate spacers.

According to the above, the method may comprise depositing a gate dielectric on the at least one channel of the fin before said act of depositing metal in the first trench and in the hole, such that the gate dielectric is deposited also in the hole, the gate dielectric and the metal being the only materials deposited in the hole.

The step of depositing metal in the first trench and in the hole may comprise:
depositing a first metal by conformal deposition, whereby the first metal forms a metal liner layer in the hole and in the first trench, the first metal being a work function metal (WFM) of the gate; and
depositing a second metal to fill the hole and the first trench, the second metal being a gate fill metal of the gate.

Thus, a high-quality gate is provided. The WFM may determine the threshold voltage of the transistor. The WFM may be formed of one or more effective WFMs (e.g. an n-type WFM such as TiAl or TiAlC and/or a p-type WFM such as TiN or TaN). The WFM may be deposited by ALD.

Thus, in the first trench and in the hole, a gate dielectric liner layer may be deposited followed by a metal liner layer, followed by a gate fill metal.

As mentioned, the substrate is etched from the backside of the substrate, to expose at least part of the metal in the hole. The substrate may first be thinned down, e.g. mechanically thinned. Prior to etching the substrate, the semiconductor structure may be attached to a carrier substrate, e.g. top side of the semiconductor structure may be attached to a carrier substrate. The original substrate may then be completely, or partially, removed. Thus, in the finished semiconductor structure, e.g. the finished transistor, the original substrate may be absent.

Material deposited in the hole may form a protrusion after said step of etching the substrate. Thus, the metal exposed by the step of etching from the backside of the substrate, may form a protrusion. This may facilitate contacting the via to the back side metal track.

The method may further comprise: removing, before said step of forming the backside metal track, a bottom portion of the gate dielectric liner layer. Thus, the back side metal track may contact the metal directly. Thereby further facilitating a good electrical connection between the via and the backside metal track.

The method may further comprise: removing, before said step of forming the backside metal track, a bottom portion of the metal liner layer. Thus, the back side metal track may contact the gate fill metal directly. Thereby further facilitating a good electrical connection between the via and the backside metal track.

The backside metal track may be formed by patterning and metal deposition, e.g. physical vapor deposition of metal. The backside metal track may be arranged in parallel with the at least one channel. Alternatively, other directions are possible.

In the above, the semiconductor structure has primarily been described as a semiconductor structure for manufacturing a NSFET. However, the method is applicable also to manufacturing a stack of NSFETs (e.g. a CFET) or a forksheet FET.

When manufacturing a stack of NSFETs, the fin may comprise channel layers of both the first NSFET and the second NSFET (stacked on top of the first NSFET). The sacrificial gate may be a sacrificial gate straddling one or both NSFETs of the stack of NSFETs.

When manufacturing a forksheet FET, the sacrificial gate may be a sacrificial gate straddling two fins separated by an insulating wall, wherein the two fins comprise the respective channel layers of the pair of transistors constituting the forksheet FET.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1a illustrates a top view of a semiconductor structure
Fig. 1b illustrates a top view of a semiconductor structure
Fig. 2 illustrates a top view of sacrificial gates on fins
Fig. 3a-g illustrate a method for forming a semiconductor structure

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

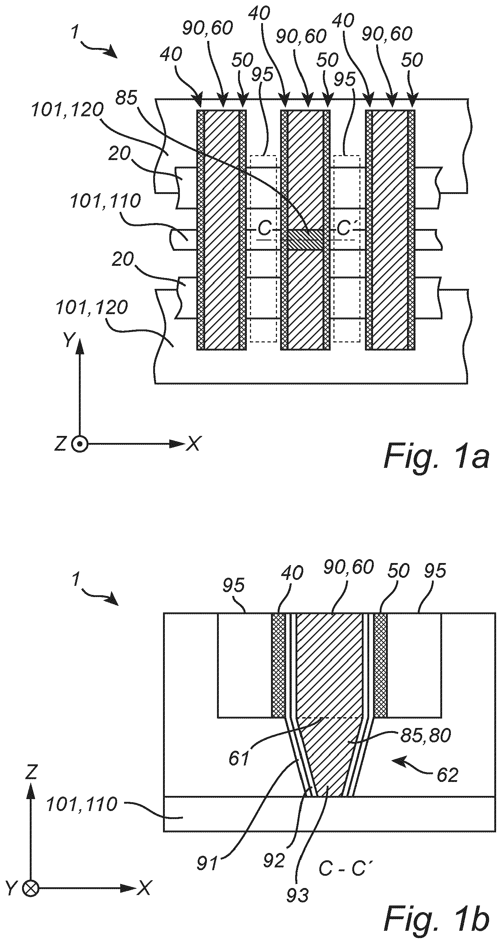

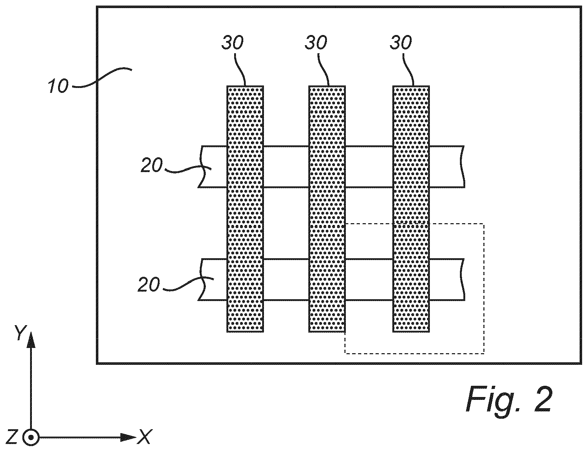

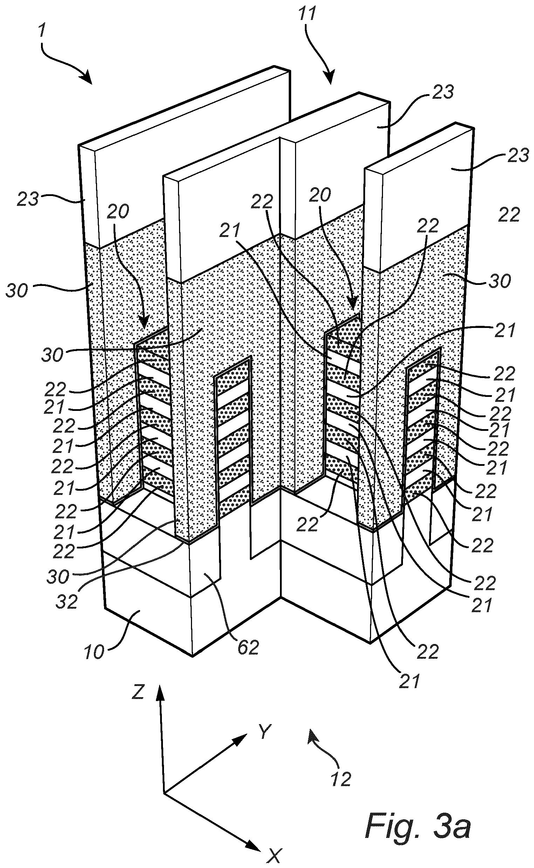

Figs. 1a-b illustrate a semiconductor structure 1, in particular a semiconductor structure 1 for forming a NSFET. In the following, various features of the semiconductor structure 1 will be discussed. The formation of the semiconductor structure 1 will be discussed further in conjunction with Fig. 2 and Figs 3a-g.

Axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate 10. The Z-direction is parallel to a normal direction to the substrate 10.

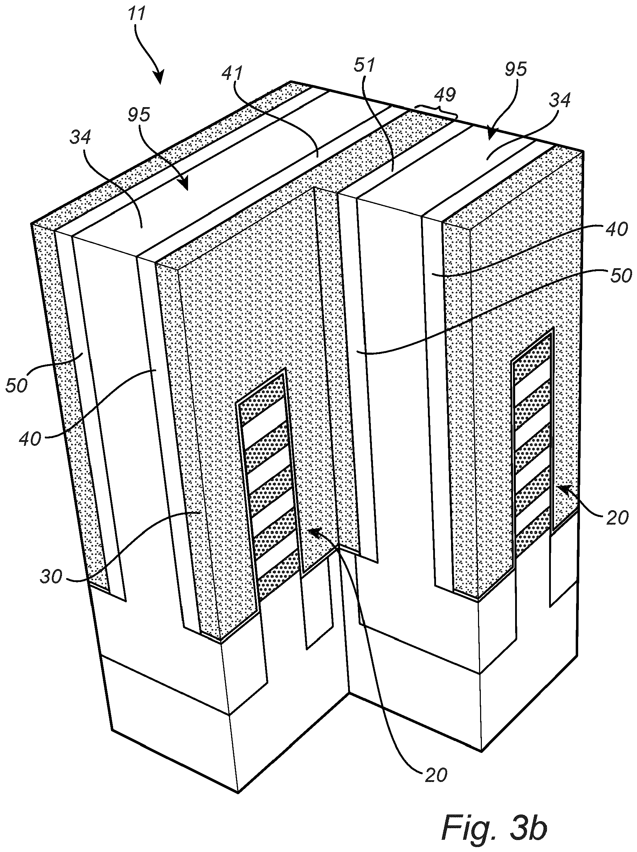

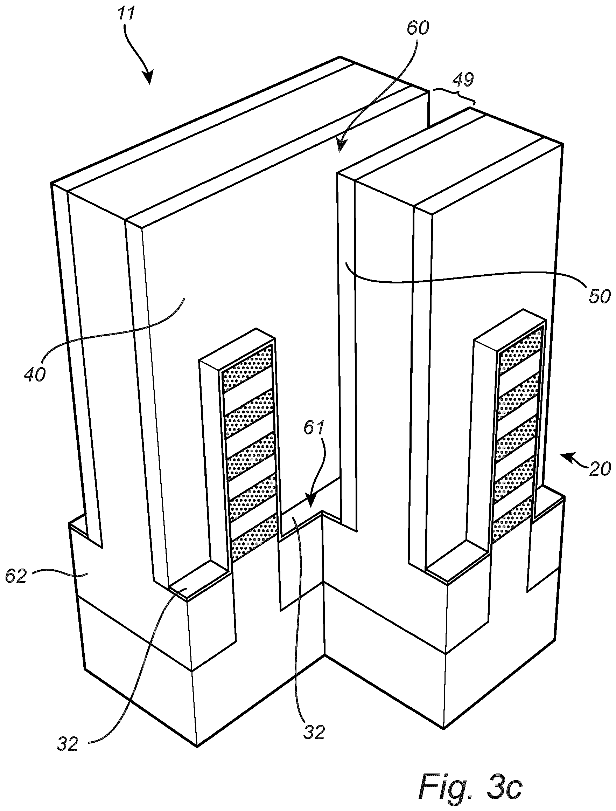

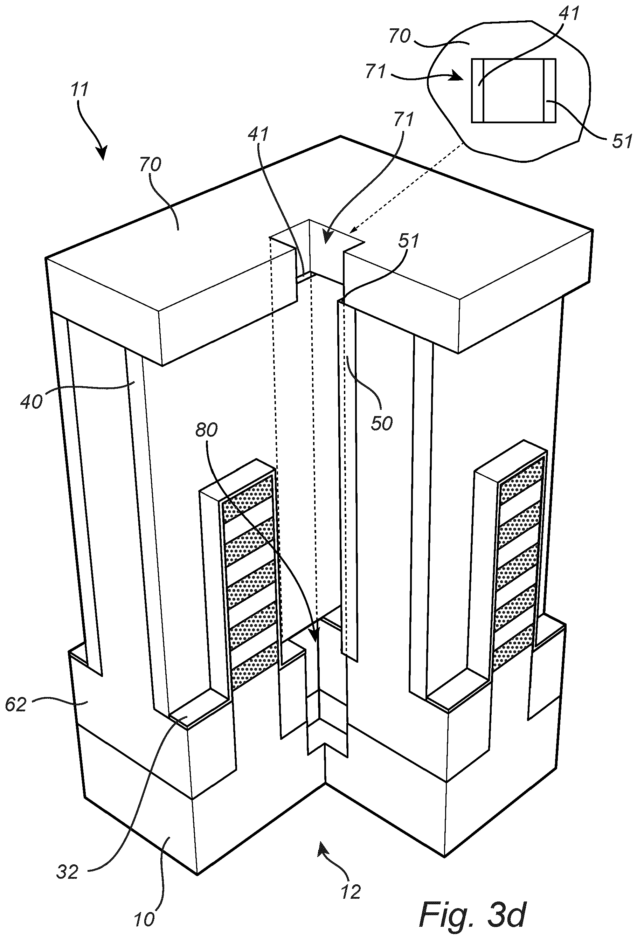

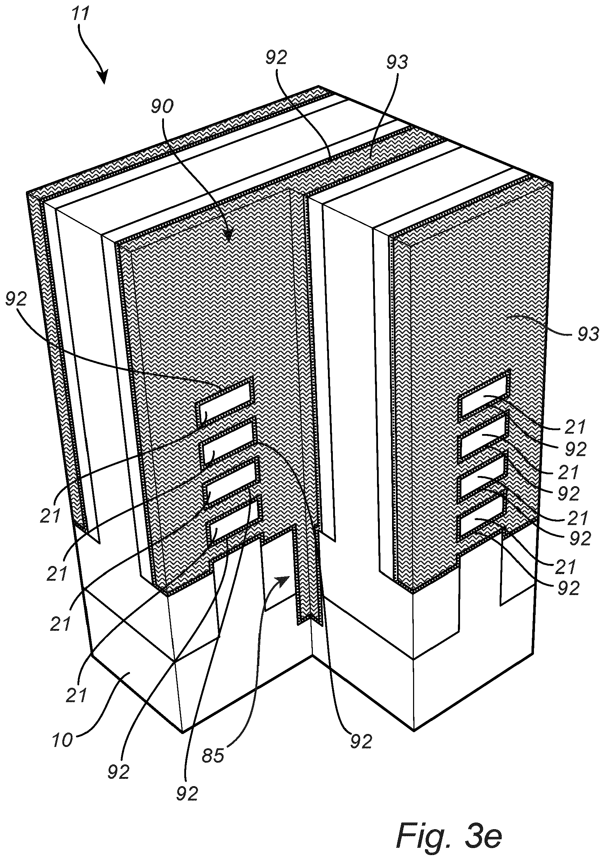

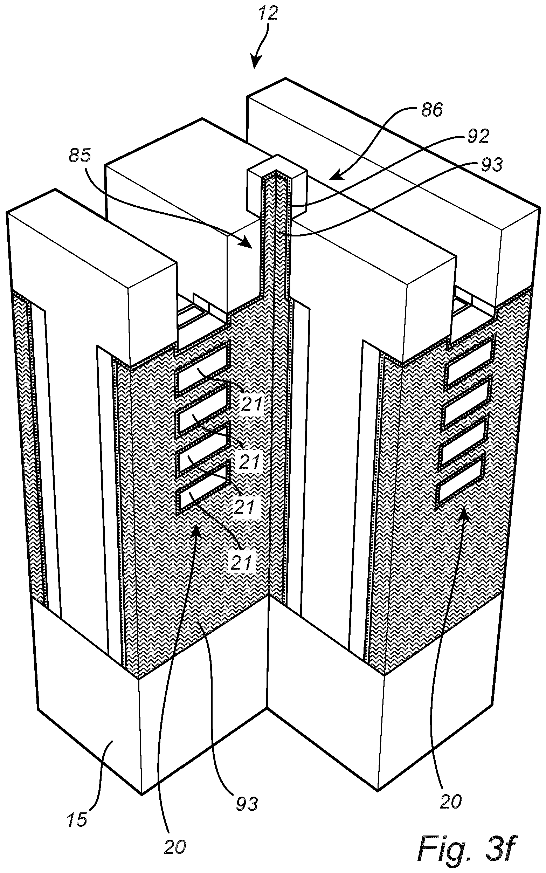

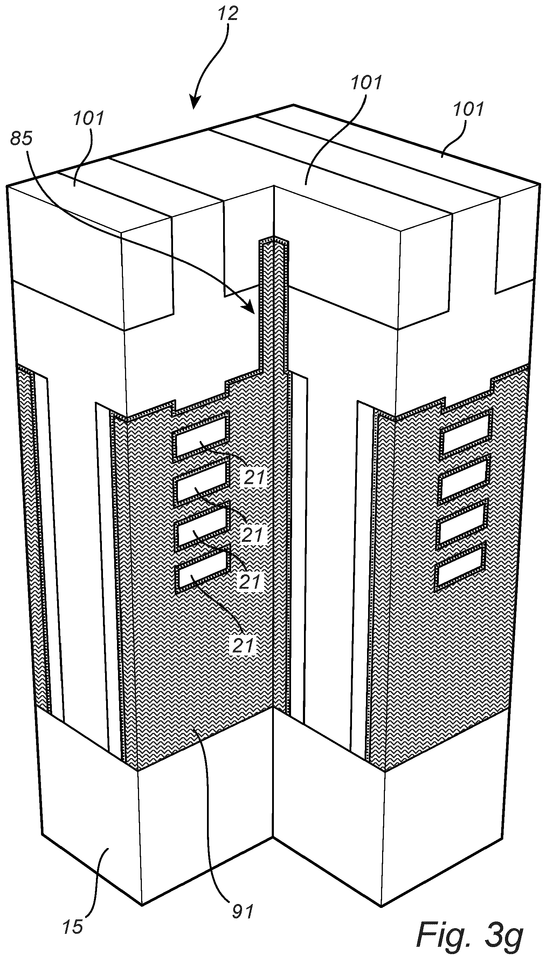

Fig. 1a illustrates a top view of the semiconductor structure 1. The figure shows two fins 20. Each fin 20 comprises at least one channel 21 (not shown). The figure further shows three gates 90. Each gate 90 straddles a fin 20. In the figure, each gate 90 straddles two fins 20. As seen in this top view, each gate 90 is arranged on the top face (i.e. top side) of the respective fins 20. Each gate 90 is further arranged on the two opposing lateral side faces of the respective fins 20, which will be apparent in the perspective views of Fig. 3. Each gate 90 comprises metal filling a first trench 60. The figure further shows that each gate 90 is arranged between a first gate spacer 40 and a second gate spacer 50. The first 40 and the second 50 gate spacer also straddle the fin 20.

Fig. 1a further illustrates two contact trench regions 95. In each of said regions, a contact trench may be formed by recessing the fins 20. A long fin 20 may then be cut into several shorter fins 20. Source/drain regions may then be formed (e.g. by epitaxial growth) on the end faces of said shorter fins 20 and contacted (e.g. by metal deposition). The contact trenches may be formed in the contact trench regions 95 before, during, or after the formation of the semiconductor structure 1, when manufacturing a transistor. Thus, in Fig. 1a, one transistor (e.g. NSFET) may be formed from one of the fins 20 between the two contact trench regions 95 and another transistor (e.g. NSFET) may be formed from the other fin 20 between the two contact trench regions 95.

Fig. 1a further illustrates backside metal tracks 101 below the two fins 20. Backside metal tracks 101 in the form of one signal track 110 and two power tracks 120 are shown. Power tracks 120 may be electrically connected to source/drain regions (not shown). Signal tracks 110 may be electrically connected to one or more gates 90.

Fig. 1a further illustrates a via 85 which electrically connects the gate 90 with the signal track 110. The illustrated via 85 simultaneously connects the gates 90 of both fins 20 to the signal track 110.

Fig. 1b shows a cross-sectional view of the semiconductor structure 1 taken along vertical plane C-C' (parallel to the XZ-plane) through the via 85. As illustrated in Fig. 1b, the via 85 is a hole 80 filled with metal, the hole 80 extending downwards from the bottom 61 of the first trench 60. The via 85 extends down to the signal track 101, 110. In the figure, the hole 80 (and thereby also the via 85) tapers. Such tapering may originate from etching the hole 80.

In Fig. 1b, the hole 80 extends into a shallow trench isolation 62. Further, in Fig. 1b, a gate dielectric liner layer 91 and a metal liner layer 92 are seen lining the sides of the first trench 60 the hole 80. The rest of the first trench 60 the hole 80 is filled with a gate fill metal 93.

In Fig. 1b, the hole 80 is self-aligned with a region between the first 40 and the second 50 gate spacer. Thus, the hole 80 does not deviate, in the lateral direction X, outside the boundaries set by the first 40 and the second 50 gate spacers. Thus, the hole 80 is self-aligned in the X-direction.

In Fig. 1b, a top portion of the left side wall of the hole 80 is aligned with the first gate spacer 40. Thus, a top portion of the left side wall of the hole 80 lies in the same plane as the first gate spacer 40. Had the hole 80 not tapered, the entire left side wall of the hole 80 may have been in the same plane as the first gate spacer 40.

Similarly, in Fig. 1b, a top portion of the right side wall of the hole 80 is aligned with the second gate spacer 50. Thus, a top portion of the right side wall of the hole 80 lies in the same plane as the second gate spacer 50. Had the hole 80 not tapered, the entire right side wall of the hole 80 may have been in the same plane as the second gate spacer 50.

Due to the hole 80 being self-aligned with the region between the first 40 and the second 50 gate spacer, the via 85 does not touch the contact trench area 95.

In the following, the formation of the semiconductor structure 1 will be discussed in conjunction with Fig. 2 and Figs 3a-g.

The method comprises forming a fin 20 and forming a sacrificial gate 30 straddling the fin 20.

Fig. 2 schematically illustrates a top view of two fins 20 and three sacrificial gates 30 that may be used to produce semiconductor structures 1 similar to the ones shown in Figs 1a-b.

Fig. 3a illustrates a perspective view of the structure in Fig. 2. Figs 3b-g illustrate further processing steps, for forming the semiconductor structure 1. All of Figs 3a-g are illustrated in a cut-away view for clarity. The cut-away is indicated by the dashed lines in Fig. 2. The processing steps of Figs 3a-g may be performed in the order presented. Alternatively, another order may be used, at least for some steps.

The fins 20 shown in Fig. 3a extend in the X-direction. The fins 20 shown in Fig. 3a are formed from a stack of layers arranged on a substrate 10. The frontside 11 of the substrate 10 and the backside 12 of the substrate 10 are indicated in the figure. The stack of layers comprises channel layers 21 (e.g. comprising solely Si) and sacrificial layers 22 (e.g. comprising SiGe). Each channel layer 21 is sandwiched between two sacrificial layers 22. The fins 20 may be etched out of the stack of layers.

As further shown in Fig. 3a, shallow trench isolation 62 may be deposited, e.g. by plasma enhanced chemical vapor deposition, to laterally surround a bottom portion of the fin 20. The shallow trench isolation may comprise an oxide, e.g. SiO₂.

As further shown in Fig. 3a, a fin cover layer 32 may cover the fin 20. The fin cover layer 32 may alternatively be called dummy gate oxide. The fin cover layer 32 may comprise an oxide, e.g. SiO₂. The oxide of the fin cover layer 32 may be a thermal oxide, e.g. produced by oxidation of the fin 20 at a high temperature. Alternatively, the fin cover layer 32 may be deposited by plasma enhanced atomic layer deposition. The fin cover layer 32 may protect the channel layers during the processing of the device, e.g. during a full gate etch.

In Fig. 3a, sacrificial gates 30 straddles the fins 20. The sacrificial gates 30 may comprise amorphous silicon or polycrystalline silicon.

Sacrificial gates 30 may be formed by encasing the fins in a layer of sacrificial gate material and arranging a hardmask 23 above. Unmasked portions of the sacrificial gate material may then be removed, e.g. by etching, thereby leaving the sacrificial gates 30 straddling the respective fins 20, as seen in the figure. In Fig. 3a, hardmask lines 23 extending in the Y-direction, across the fins 20 are seen.

Fig. 3b shows the result of a first gate spacer 40 and a second gate spacer 50 being arranged on opposite sides of the sacrificial gate 30. The illustrated first 40 and second 50 gate spacers are arranged on sides of the sacrificial gate 30 orthogonal to the X-direction. Thus, the illustrated first 40 and second 50 gate spacers also straddles the fin 20. The first 40 and second 50 gate spacers may be conformally deposited, e.g. by atomic layer deposition, on the opposite side surfaces of the sacrificial gate 30. The material of the first 40 and the second 50 gate spacer may be a silicon nitride, e.g. Si₃N₄. The illustrated first 40 and second 50 gate spacers are separated by a separating distance 49, corresponding to a thickness of the sacrificial gate 30.

In Fig. 3b, an oxide 34, e.g. SiO₂, has been deposited in the contact trench regions 95. Within said contact trench regions 95, the fins 20 may have been recessed, source/drain regions may have been formed, source/drain regions may have been contacted, e.g. before depositing the oxide 34.

Fig. 3c shows the result of forming a first trench 60 between the first 40 and the second gate spacer 50. The first trench 60 has been formed by etching the sacrificial gate 30 from the frontside 11 of the substrate 10. The first trench 60 may be etched by an etchant having a high etch rate on amorphous silicon and a low etch rate on oxides and nitrides. As illustrated, the first trench 60 may be etched down to the fin cover layer 32, e.g. to a portion of the fin cover layer 32 which is arranged on the shallow trench isolation 62. Thus, a bottom 61 of the first trench 60 may lie at the fin cover layer 32.

Fig. 3d shows the result of forming a hole 80 extending from the bottom 61 of the first trench 60 towards the backside 12 of the substrate 10. The hole 80 is formed subsequent to the etching of the sacrificial gate 30. The illustrated hole 80 extends into the shallow trench isolation 62 and into the substrate 10.

The etchant used for forming the hole 80 may have a low etch rate on the material of the first 40 and second 50 gate spacer and a high etch rate on the shallow trench isolation 62. For example, the etchant used for forming the hole 80 may have a low etch rate on Si₃N₄, and a high etch rate on SiO₂.

The hole 80 may be formed using a mask layer 70 comprising a mask opening 71. In Fig. 3d, a top surface of a mask layer 70 comprising a mask opening 71 is schematically illustrated. In the figure, the mask opening 71 exposes a part of the first trench 60, a part of a top surface 41 of the first gate spacer 40, and a part of a top surface 51 of the second gate spacer 50. In the figure, the extent of the hole 80 is defined by the part of the first trench 60 exposed by the mask opening 71 and the first 40 and second 50 gate spacers are not etched. Thus, in the figure, the width 89 of the hole 80 in the direction of the separating distance 49 is equal to the separating distance 49 between the gate spacers 40, 50. In other words, even if the mask opening is bigger than the separating distance 49 between the gate spacers 40, 50, or is unintentionally shifted with respect to the gate spacers 40, 50, the hole 80 may be self-aligned to the gate spacers 40, 50.

The position and size of the mask opening 71 may be lithographically defined. For example, a photoresist may be deposited and lithographically patterned to define the mask opening 71.

Fig. 3e shows the result of depositing metal in the first trench 60 and in the hole 80. In Fig. 3e, a gate 90 and a via 85 have been formed by the metal. In the figure, the fin cover layer 32 has been removed prior to forming the gate 90 and the via 85. Similarly, in the figure, the sacrificial layers 22 of the fins 20 have been removed prior to forming the gate 90 and the via 85. The gate 90 and the via 85 may be formed by depositing a gate dielectric liner layer 91 followed by a metal liner layer 92, followed by a gate fill metal 93.

The gate dielectric liner layer 91 is not shown in Fig. 3e but may extend in parallel with the shown metal liner layer 92. The gate dielectric liner layer comprise a conventional a high-k dielectric e.g. HfO₂, HfSiO, LaO, AlO or ZrO. The gate dielectric liner layer may be conformally deposited, e.g. by ALD.

The metal liner layer 92 may comprise a WFM. The WFM may be formed of one or more effective WFMs (e.g. an n-type WFM such as TiAl or TiAlC and/or a p-type WFM such as TiN or TaN). The WFM may be conformally deposited, e.g. by ALD.

The gate fill metal 93 may comprise e.g. W, Al, Co or Ru. The gate fill metal 93 may be deposited by e.g. chemical vapor deposition or physical vapor deposition.

The gate 90 illustrated in Fig. 3e extends around each channel 21 to form a gate-all-around.

Fig. 3f shows the result of etching the substrate 10 from the backside 12 of the substrate 10, to expose at least part of the metal in the hole 80. In Fig. 3f, the top side of the semiconductor structure 1 has been attached to a carrier substrate 15. The semiconductor structure 1 has then been flipped upside down and the substrate 10 has been etched away. Prior to etching, the substrate 10 may be thinned down, e.g. mechanically thinned. The etching may, as shown, remove also a bottom portion of the fin 20. Further, at least part of the dielectric liner layer 91 may be removed, e.g. by etching from the back side of the substrate 10.

In fig. 3f, the exposed metal, in this case the metal liner layer 92 and the gate fill metal 93, forms a protrusion 86.

Fig. 3g shows the result of forming a backside metal track 101 on the exposed metal. The backside metal track 101 may be formed by patterning and metal deposition. Areas between backside metal tracks 101 may be felled with an electrical insulator, e.g. an oxide, e.g. SiO₂. The protrusion 86 may be removed before forming the backside metal track 101. For example, a bottom portion of the metal liner layer 92 may be removed before forming the backside metal track 101.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor structure (1), the method comprising:
forming a fin (20) comprising at least one channel (21), the at least one channel (21) comprising a semiconductor, the fin (20) being arranged on top of a substrate(10);
forming a sacrificial gate (30) straddling the fin (20);
forming a first gate spacer (40) and a second gate spacer (50), the first (40) and the second gate spacer (50) straddling the fin (20) and being arranged on opposite sides of the sacrificial gate (30);
forming a first trench (60) between the first (40) and the second gate spacer (50), by etching, from a frontside (11) of the substrate (10), the sacrificial gate (30);
forming a hole (80) by etching from the frontside (11) of the substrate (10), the hole (80) extending from a bottom (61) of the first trench (60) towards a backside (12) of the substrate (10), said act of forming the hole (80) being subsequent to said act of etching the sacrificial gate (30);
depositing metal in the first trench (60) and in the hole (80) such that the metal deposited in the first trench (60) forms at least part of a gate (90) for the at least one channel (21) of the fin (20);
etching the substrate (10) from the backside (12) of the substrate (10), to expose at least part of the metal in the hole (80);
forming a backside metal track (101) on the exposed metal, wherein the backside metal track (101) is in electrical connection with the gate (90) by the metal in the hole (80).

2. The method according to claim 1, further comprising:
depositing, prior to forming the hole (80), a mask layer (70) comprising a mask opening (71), the mask opening (71) exposing a part of the first trench (60) and a part of a top surface (41,51) of at least one of the first (40) and the second gate spacer (50), wherein an extent of the hole (80) is defined by the part of the first trench (60) exposed by the mask opening (71).

3. The method according to any one of previous claims, wherein the first gate spacer (40) and the second gate spacer (50) are separated by a separating distance (49), wherein a width of the hole (80) in a direction of the separating distance (49) is smaller than or equal to the separating distance (49).

4. The method according to claim 3, wherein a width of the hole (80) in a direction of the separating distance (49) is equal to the separating distance (49).

5. The method according to any one of previous claims, wherein, in said step of forming the hole (80) by etching, an etch rate is higher for a material at the bottom (61) of the first trench (60) than for a material of the first (40) and the second gate spacer (50)

6. The method according to any one of previous claims, wherein the hole (80) extends into a shallow trench isolation (62), STI.

7. The method according to any one of previous claims , the method further comprising
depositing a gate dielectric on the at least one channel (21) of the fin (20) before said act of depositing metal in the first trench (60) and in the hole (80), such that the gate dielectric is deposited also in the hole (80), the gate dielectric and the metal being the only materials deposited in the hole.

8. The method according to any one of previous claims, wherein the metal exposed by the step of etching from the backside (12) of the substrate (10), forms a protrusion.

9. The method according to any one of previous claims, wherein a thickness of the first gate spacer (40) and the second gate spacer (50) is at least 4 nm.

10. The method according to any one of previous claims,
wherein the step of depositing metal in the first trench (60) and in the hole (80) comprises:
depositing a first metal by conformal deposition, whereby the first metal forms a metal liner layer (92) in the hole (80) and in the first trench (60), the first metal being a work function metal of the gate (90);
depositing a second metal to fill the hole (80) and the first trench (60), the second metal being a gate fill metal (93) of the gate (90);
the method further comprising:
removing, before said step of forming the backside metal track (101), a bottom portion of the metal liner layer (92).

11. The method according to any one of the preceding claims, wherein the material of the first (40) and the second gate spacer (50) is a silicon nitride

12. A semiconductor structure (1), the semiconductor structure (1) comprising:
a fin (20) comprising at least one channel (21), the at least one channel (21) comprising a semiconductor;
a first gate spacer (40) and a second gate spacer (50), the first (40) and the second gate spacer (50) straddling a top side of the fin (20);
a gate (90) for the at least one channel (21) of the fin (20), the gate (90) straddling the top side of the fin (20) and being arranged between the first (40) and the second gate spacer (50), the gate (90) comprising metal filling a first trench (60), the first trench (60) being arranged between the first (40) and the second gate spacer (50);
a hole (80) filled with metal, the hole (80) extending downwards from a bottom (61) of the first trench (60), the hole (80) being self-aligned with a region between the first (40) and the second (50) gate spacer;
a backside metal track (101) in electrical connection with the gate (90) by the metal in the hole (80).

13. The semiconductor structure (1) according to claim 12, wherein the hole (80) extends into a shallow trench isolation (62), STI.
